# FASCICULE DE BREVET EUROPEEN

(11) **EP 3 054 402 B1**
(45) Date de publication et mention de la délivrance du brevet: **01.11.2017**
(21) Numéro de dépôt: 16152870.8
(22) Date de dépôt: 27.01.2016
(51) Int. Cl.: G06K 19/07

(54) **PUCE MICROÉLECTRONIQUE AVEC MULTIPLES PLOTS**
MIKROELEKTRONISCHER CHIP MIT MEHREREN PLOTS
MICROELECTRONIC CHIP WITH MULTIPLE PADS

(30) Priorité: 27.01.2015 FR 1550590
(43) Date de publication de la demande: 10.08.2016
(73) Titulaire: Starchip, 13590 Meyreuil (FR)
(72) Inventeur: PALMADE, Romain, Pierre, 92130 ISSY LES MOULINEAUX (FR)
(74) Mandataire: Regimbeau

(56) Documents cités:
- EP-A2- 1 538 558
- WO-A1-98/40846
- WO-A1-02/089053

## Description

### DOMAINE TECHNIQUE GENERAL

La présente invention concerne le domaine des cartes à puce. Plus précisément, elle concerne une puce d'une carte à puce sans contact ou à fonctionnement dual à contact et sans contact.

### ETAT DE LA TECHNIQUE

Les cartes à puce sans contact permettent de réaliser une transmission d'information à courte distance entre un lecteur et une puce disposée au sein d'un module électronique de la carte à puce sans nécessiter l'insertion de la carte dans un lecteur et l'établissement d'un contact électrique entre le lecteur et des contacts métalliques du module électronique.

Pour cela, une carte à puce sans contact dispose d'une antenne reliée à la puce permettant une communication radiofréquence entre la carte et le lecteur de carte. Une carte à puce sans contact ne disposant d'aucune source ni stockage d'énergie, une telle antenne permet également à la puce de la carte d'être alimentée par induction.

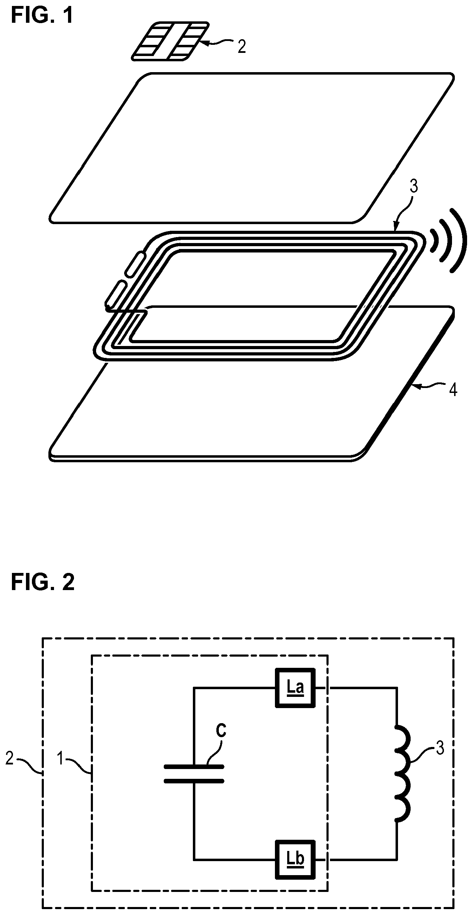

Traditionnellement, une telle carte à puce est au format carte de crédit et l'antenne 3 de la carte est disposée sur le substrat 4 du corps de carte, comme représenté en **figure 1****.** L'antenne est alors reliée à la puce par l'intermédiaire du module électronique 2. Une telle antenne est alors de dimensions suffisantes pour assurer une alimentation électrique correcte de la puce.

Néanmoins, la progression constante de la miniaturisation des systèmes électroniques rend aujourd'hui nécessaire l'intégration de puces sans contact dans des supports de dimensions bien inférieures à celles d'une carte de crédit. L'antenne 3 reliée à la puce 1 ne peut alors plus être placée dans un corps de carte et doit être intégrée au module électronique 2, comme représenté en **figure 2****.** L'antenne est alors reliée directement à deux plots de contact La et Lb de la puce 1. La puce 1 comprend également une capacité C utilisée pour mettre l'antenne en résonance. Or, le faible espace disponible dans un tel module ne permet pas d'y intégrer une antenne de mêmes dimensions que celles résidant dans le corps des cartes à puce sans contact existantes. L'énergie pouvant être collectée par une antenne située dans un module électronique sera alors bien plus faible, au point de risquer d'être insuffisante pour assurer une alimentation électrique correcte de la puce.

Il existe donc un besoin d'un système permettant d'assurer une alimentation électrique correcte d'une puce sans contact, tout en respectant les contraintes de faible surface disponible imposées par les petites dimensions du module électronique au sein de laquelle la puce est disposée.

### PRESENTATION DE L'INVENTION

La présente invention propose selon un premier aspect un module électronique pour carte à puce à fonctionnement sans contact ou à fonctionnement dual à contact et sans contact, comprenant au moins une première antenne, une seconde antenne, une troisième antenne et une puce microélectronique, caractérisé en ce que :
ladite puce microélectronique comprend un microprocesseur, au moins un premier plot, un deuxième plot, un troisième plot, un quatrième plot, une première capacité d'accord connectée entre le premier plot et le troisième plot, une deuxième capacité connectée entre le deuxième plot et le quatrième plot, lesdits premier et troisième plots étant reliés aux entrées/sorties du microprocesseur et aptes à assurer la transmission à celui-ci d'un signal de communication radiofréquence échangé via les antennes,
ladite première antenne est connectée entre le premier plot et le troisième plot et configurée pour être mise en résonance par ladite première capacité, ladite seconde antenne est connectée entre le deuxième plot et le quatrième plot et configurée pour être mise en résonance grâce à la deuxième capacité pour capter de l'énergie transmise par induction par un lecteur distant,
ladite troisième antenne est branchée en série avec ladite seconde antenne entre le deuxième plot et le quatrième plot pour transmettre l'énergie captée à la puce microélectronique et couplée avec la première antenne pour transférer l'énergie captée par la seconde antenne à la puce microélectronique par l'intermédiaire de la première antenne.

Une telle puce permet de prévoir des montages électriques permettant d'assurer son alimentation électrique malgré la faible surface disponible au niveau du module électronique et sans nécessiter de composants en dehors de celui-ci.

Un tel module permet de disposer de plusieurs antennes dans deux circuits couplés pour augmenter la quantité d'énergie captée et transmise à la puce. L'alimentation électrique de la puce peut ainsi être assurée malgré la faible surface disponible au niveau du module électronique et sans nécessiter de composants en dehors de celui-ci.

La deuxième capacité peut être une capacité variable.

Une telle capacité permet de mettre en résonance de manière efficace une seconde antenne du module électronique différente d'une première antenne mise en résonance par la première capacité de la puce et d'augmenter de façon importante l'énergie captée et transmise à la puce.

La puce microélectronique peut comprendre une résistance variable connectée en série avec la deuxième capacité entre le deuxième plot et le quatrième plot.

Une telle résistance variable permet de diminuer et d'ajuster le facteur de qualité du circuit dans lequel elle est insérée, afin de régler sa bande passante.

### PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :
- la figure 1 représente un exemple de carte à puce selon l'état de la technique ;
- la figure 2 représente un exemple de puce microélectronique selon l'état de la technique ;
- la figure 3 représente un exemple de puce microélectronique selon un premier mode de réalisation de l'invention ;
- la figure 4 représente un exemple de puce microélectronique selon un deuxième exemple non représentatif de l'invention ;
- la figure 5 représente un exemple de puce microélectronique selon un troisième exemple non représentatif de l'invention ;
- la figure 6 représente un exemple de puce microélectronique selon un quatrième exemple non représentatif de l'invention ;
- la figure 7 représente un exemple de puce microélectronique selon un cinquième exemple non représentatif de l'invention ;
- la figure 8 représente un exemple de puce microélectronique selon un sixième exemple, non représentatif de l'invention ;

### DESCRIPTION DETAILLEE

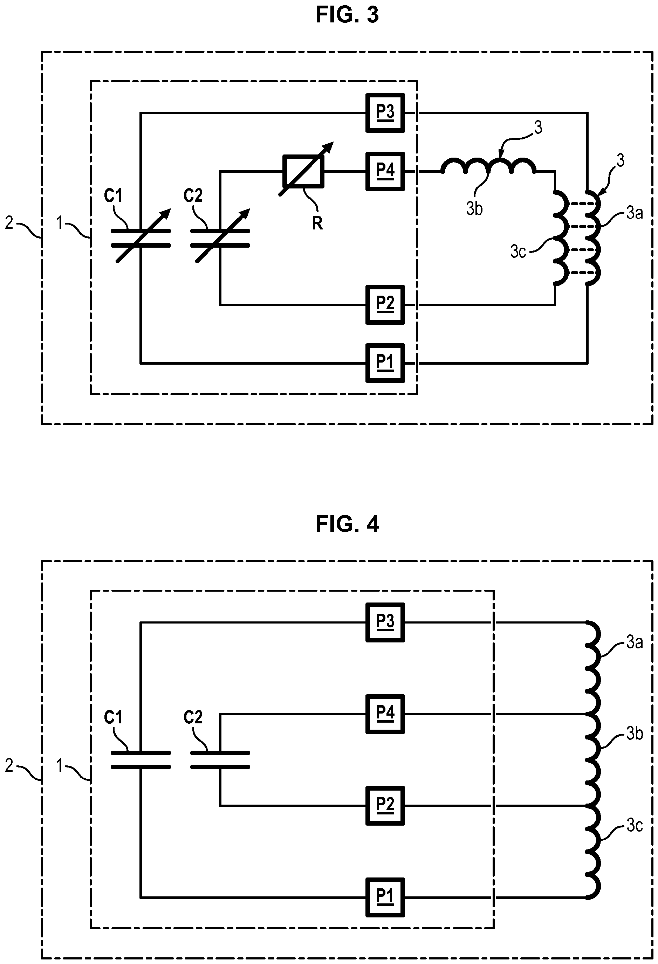

La présente invention concerne une puce microélectronique 1 pour une carte à puce à fonctionnement sans contact, représentée en **figure 3****.** Une telle carte peut être une carte purement sans contact ou bien une carte duale permettant à la fois un fonctionnement sans contact et un fonctionnement avec contact.

Une telle puce comprend au moins un microprocesseur, un premier plot P1 et un deuxième plot P2. La puce 1 est susceptible d'être insérée dans un module électronique 2 comprenant au moins une antenne 3 apte à être connectée à la puce 1 par le biais desdits plots P1, P2 pour assurer une communication radiofréquence avec un lecteur distant.

Ladite au moins une antenne 3 a également pour fonction de collecter de l'énergie transmise par le lecteur distant par induction, pour alimenter la puce 1. L'énergie captée par l'antenne peut également être transmise à la puce par le biais desdits plots P1, P2.

Au sein de la puce, une telle énergie est plus précisément utilisée pour alimenter le microprocesseur et les autres circuits de la puce à alimenter tels qu'une mémoire ou un cryptoprocesseur dédié à l'accélération de calculs cryptographiques. Pour cela, la puce comprend en outre au moins un troisième plot P3, et deux des plots de la puce, par exemple les premier et troisième plots P1 et P3, sont reliés aux entrées/sorties du microprocesseur, assurant ainsi la transmission à celui-ci de l'énergie captée et d'un signal de communication radiofréquence échangé via l'antenne.

La puce 1 comprend également deux capacités C1 et C2 et au moins un de ses plots, par exemple le deuxième plot P2, est distinct des deux plots reliés aux entrées/sorties du microprocesseur. Ce plot est apte à être relié, ainsi qu'au moins un autre plot, à l'au moins une antenne 3 pour assurer le chargement par celle-ci desdites capacités C1 et C2. A titre d'exemple, la capacité C1 peut avoir une capacité comprise entre 20 pF et 70 pF ; et la capacité C2 une capacité comprise entre 100 pF et 200 pF.

Les premier et deuxième plots de la puce P1 et P2 sont conçus pour être reliés à l'antenne 3 du module et sont donc des connecteurs externes par le biais desquels des composants externes à la puce situés sur le module électronique, peuvent être connectés à la puce. Les autres plots de la puce peuvent se présenter également comme des connecteurs externes auxquels des composants externes peuvent être connectés. Alternativement, ces autres plots peuvent n'être que des plots internes à la puce, sans possibilité de connexion directe depuis l'extérieur de celle-ci.

Par distinct des plots reliés aux entrées/sorties du microprocesseur, on entend que le deuxième plot P2 n'est pas placé à un point du circuit électrique de la puce 1 dont le potentiel est toujours égal à celui des plots reliés aux entrées/sorties du microprocesseur. Ce plot n'est ainsi ni physiquement confondu ni directement relié par un fil au sein de la puce aux plots reliés aux entrées/sorties du microprocesseur. Ceci ne préjuge pas des connexions pouvant être réalisées entre les plots à l'extérieur de la puce dans le cas où le troisième plot P3 se présente aussi sous la forme d'un connecteur externe.

La puce comprend ainsi au minimum trois plots dont un premier plot P1 et un deuxième plot P2 sous la forme de connecteurs externes, et un troisième plot P3 distinct, relié aux entrées/sorties du microprocesseur et pouvant lui-même se présenter ou non sous la forme d'un connecteur externe. Un autre plot de la puce est relié aux entrées/sorties du microprocesseur. Ce plot peut être le premier plot P1 ou le deuxième plot P2 ou bien un plot supplémentaire sous la forme ou non d'un connecteur externe.

Lorsqu'ils se présentent sous la forme de connecteurs externes, les plots reliés aux entrées/sorties du microprocesseur peuvent également être reliés à l'au moins une antenne 3 du module.

Dans un exemple de réalisation représenté en Figure 3, le troisième plot P3 se présente sous la forme d'un connecteur externe et le premier plot P1 est relié aux entrées/sorties du microprocesseur.

Comme représenté en figure 3, la puce 1 peut comprendre un quatrième plot P4, la première capacité C1 peut être une capacité d'accord connectée entre les premier et troisième plots P1 et P3, et la deuxième capacité C2 peut être connectée entre les deuxième et quatrième plots P2 et P4. Une capacité comprise entre 20 pF et 70 pF permet ainsi de mettre en résonnance une inductance L comprise entre 1,5 µH et 6 µH.

Comme représenté en figures 3 et 4, ladite au moins une antenne 3 peut alors être connectée à la puce par quatre points de potentiels distincts connectés auxdits plots P1, P2, P3, P4 pour assurer une communication radiofréquence avec un lecteur distant et une alimentation de ladite puce,

Le fait de disposer au sein de la puce de deux capacités et d'au moins trois plots disposés de sorte qu'au moins un des plots de la puce relié à l'antenne 3 ne soit confondu avec aucun des deux plots reliés aux entrées/sorties du microprocesseur permet de réaliser différents circuits interconnectant ces capacités avec l'au moins une antenne 3 par l'intermédiaire des plots de sorte à fournir davantage d'énergie que lors de la liaison directe d'une antenne du module électronique aux deux plots reliés aux entrées/sorties du microprocesseur. Celui-ci pourra ainsi recevoir suffisamment d'énergie pour être correctement alimenté.

Le fait de disposer de quatre plots permet par exemple de constituer deux circuits séparés comprenant chacun son antenne et la capacité pour la faire entrer en résonance.

Comme représenté en figure 3, la deuxième capacité C2 peut être une capacité variable, par exemple entre 100 pF et 200 pF, de manière à simplifier la mise en résonance d'une antenne connectée entre les deuxième et quatrième plots P2 et P4. La valeur de la capacité C2 peut être sélectionnable par le microprocesseur en fonction de la valeur de l'au moins une antenne connectée aux plots de la puce.

Par ailleurs, comme représenté en figure 3, la puce 1 peut comprendre une résistance variable R connectée en série avec la deuxième capacité C2 entre les deuxième et quatrième plots P2 et P4. Comme dans le cas de la capacité C2 variable, la valeur de la résistance R peut être sélectionnée par le microprocesseur. Une telle résistance en série permet de diminuer le facteur de qualité du circuit Q = 1/(4RCω) afin d'améliorer sa bande passante B = ω/Q, ω étant la pulsation du signal.

Selon un premier exemple représenté en figure 3, le module électronique comprend une première antenne 3a connectée entre les premier et troisième plots P1 et P3, lesquels sont également reliés aux entrées/sorties du microprocesseur. Cette antenne est mise en résonance par la première capacité C1 également branchée entre les premier et troisième plots P1 et P3.

Afin d'augmenter la quantité d'énergie collectée au niveau du module électronique et transmis à la puce, le module électronique comprend également une seconde antenne 3b, dite antenne « booster », connectée entre les deuxième et quatrième plots P2 et P4 de la puce. Une telle antenne capte également de l'énergie transmise par induction par le lecteur en étant mise en résonance grâce à la deuxième capacité C2 également connectée entre les deuxième et quatrième plots P2 et P4 de la puce. Afin de transmettre cette énergie à la puce, une troisième antenne 3c est branchée en série avec l'antenne booster 3b entre les deuxième et quatrième plots P2 et P4 de la puce. Cette troisième antenne est couplée avec la première antenne 3a et permet de transférer l'énergie captée par l'antenne booster 3b à la puce par l'intermédiaire de la première antenne 3a. La connexion des antennes 3a, 3b, 3c à la puce par quatre points de potentiels distincts permet ainsi de constituer deux circuits électriques comprenant chacun une antenne mise en résonnance et couplés entre eux, démultipliant l'énergie captée par le module électronique et transmise à la puce. De telles antennes 3a, 3b et 3c ou 3b et 3c peuvent par ailleurs constituer des éléments d'antenne d'une même antenne 3.

Une comparaison entre une antenne classique à deux plots d'antennes et une antenne à quatre plots a été faite, les deux antennes ayant une surface totale égale. Une mesure de la tension et de la puissance reçue par la puce a montré que l'antenne à quatre plots récupérait trois fois plus de puissance qu'une antenne à deux plots. La tension mesurée en sortie du pont de diode de la puce est également trois fois plus élevée ce qui permet à la puce de fonctionner sur une gamme de champ électromagnétique beaucoup plus importante et donc d'augmenter de manière significative la distance de fonctionnement.

Selon un deuxième exemple, non représentatif de l'invention, représenté en **figure 4****,** la puce 1 comprend les mêmes circuits que la configuration représentée en figure 3 et le module électronique comprend trois antennes 3a, 3b et 3c connectées respectivement entre les troisième et quatrième plots P3 et P4, les deuxième et quatrième plots P2 et P4, et les premier et deuxième plots P1 et P2. Dans cet exemple, la capacité C1 réalise l'accord des antennes et la capacité C2 amplifie l'énergie captée par celles-ci et délivrée à la puce. De telles antennes 3a, 3b et 3c peuvent par ailleurs constituer des éléments d'antenne d'une même antenne 3.

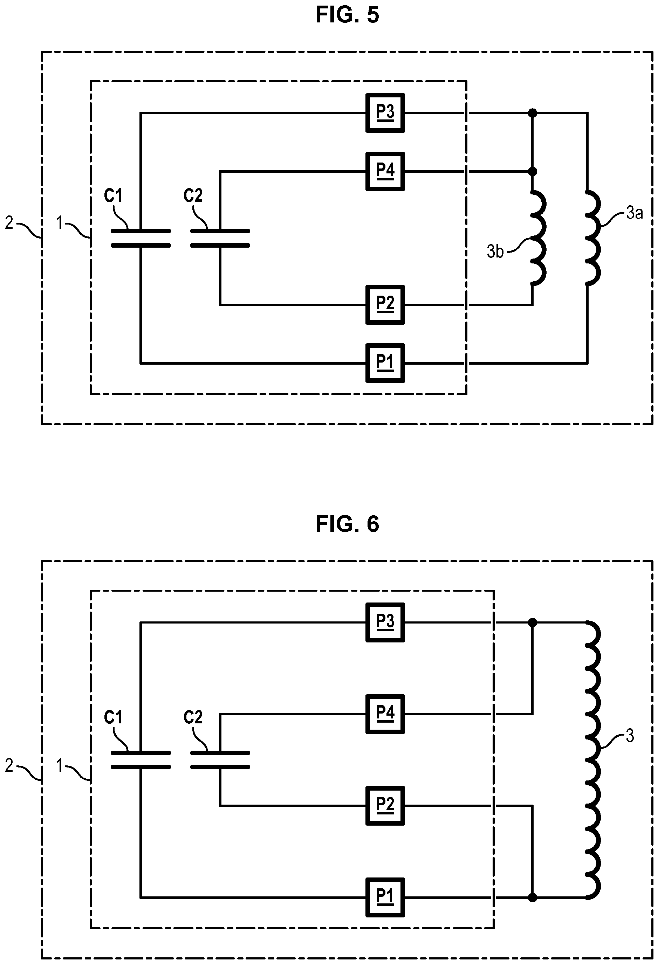

Un troisième exemple de configuration, non représentatif de l'invention, est représenté en **Figure 5** dans laquelle la puce 1 comporte les mêmes circuits que la configuration représentée en figure 3 et dans laquelle une première antenne 3a est connectée entre les premier et troisième plots P1 et P3 et une deuxième antenne 3b est connectée entre les deuxième et quatrième plots P2 et P4. De plus, les troisième et quatrième plots P3 et P4 sont reliés par un fil. Dans cet exemple, comme dans l'exemple précédent, la capacité C1 réalise l'accord des antennes et la capacité C2 amplifie l'énergie captée par celles-ci et délivrée à la puce. De plus, les troisième et quatrième plots P3 et P4 étant reliés par un fil, ceux-ci peuvent être confondus et seuls trois plots sont nécessaires.

Un quatrième exemple de configuration, non représentatif de l'invention, est représenté en **Figure 6** dans laquelle la puce 1 comporte les mêmes circuits que la configuration représentée en figure 3 et dans laquelle une antenne 3 est connectée entre les premier et troisième plots P1 et P3 et dans laquelle les troisième et quatrième plots P3 et P4 sont connectés par un fil et dans laquelle les premier et deuxième plots P1 et P2 sont connectés par un fil. Dans cet exemple, les capacités C1 et C2 servent de capacité d'accord de l'antenne 3. Leur montage en parallèle permet d'obtenir une capacité d'accord globale de valeur C1 + C2.

Selon un autre exemple non représentatif de l'invention la puce 1 peut comprendre une première capacité d'accord C1 connectée entre le premier plot P1 et le troisième plot P3 reliés aux entrées/sorties du microprocesseur, et une deuxième capacité C2 reliée au troisième plot P3 et au deuxième plot P2 de sorte que, lorsque ladite antenne 3 est connectée entre le premier P1 et le deuxième plot P2, la première capacité d'accord C1 est connectée entre lesdits premier et troisièmes plots P1 et P3 en parallèle à ladite au moins une antenne et la deuxième capacité C2 est connectée entre lesdits premier et troisièmes plots P1 et P3 en série avec ladite au moins une antenne.

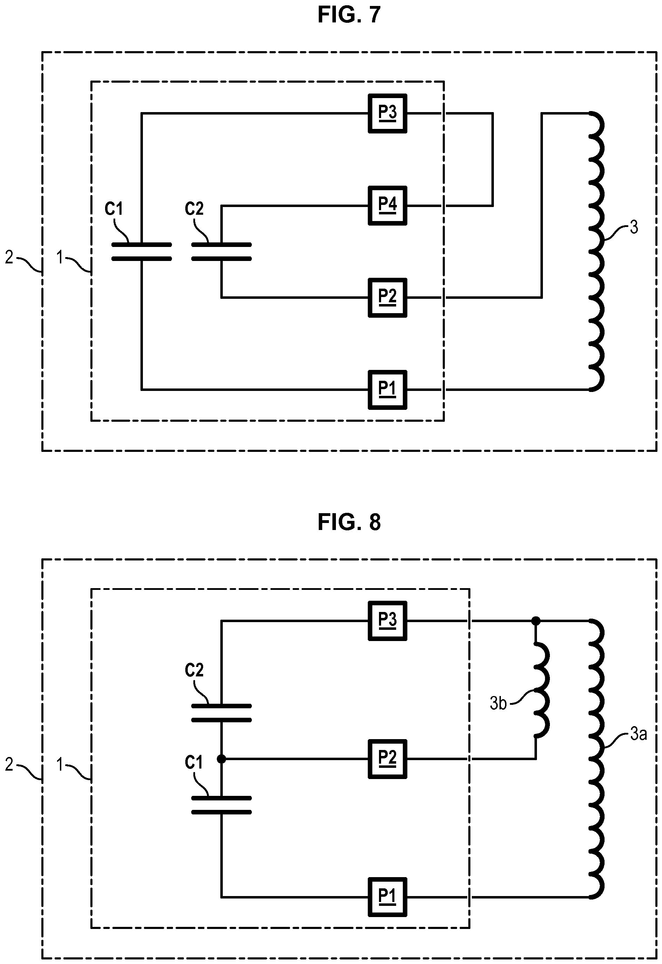

Un exemple d'une telle configuration est représenté en **figure 7** dans laquelle, comme dans les exemples des figures 3 à 6, la puce 1 comprend un quatrième plot P4 supplémentaire et tous les plots se présentent sous la forme de connecteurs externes. Dans cet exemple l'antenne 3 est connectée aux premier et deuxième plots P1 et P2, la deuxième capacité C2 est reliée au troisième plot P3 par l'intermédiaire du quatrième plot P4 et d'un fil reliant celui-ci au troisième plot P3.

Une telle configuration est néanmoins tout à fait réalisable avec uniquement trois plots, le quatrième plot P4 n'existant alors pas et la deuxième capacité C2 étant alors directement reliée au troisième plot P3. De même, il n'est pas nécessaire que le troisième plot, et le quatrième plot s'il existe, se présentent sous la forme de connecteurs externes puisqu'ils ne sont directement reliés à aucun composant à l'extérieur de la puce.

La capacité d'accord C1 permet de mettre le circuit en résonance. La capacité C2 améliore l'efficacité de l'antenne 3 en permettant de modifier la fréquence de résonnance du circuit et augmente ainsi la quantité d'énergie transmise à la puce. Un tel montage avec une capacité en série n'est possible que grâce au positionnement de cette capacité entre le plot P3 relié aux entrées/sorties du microprocesseur et le deuxième plot P2 distinct des plots reliés aux entrées/sorties du microprocesseur. Si la puce ne comprenait que deux plots, reliés tous deux aux entrées/sorties du microprocesseur, un tel montage en série ne serait possible qu'en positionnant la deuxième capacité sur le module électronique, réduisant d'autant l'espace disponible pour y loger l'antenne 3. Celle-ci risquerait alors d'être de dimensions trop petites pour alimenter correctement la puce.

Un sixième exemple de configuration, non représentatif de l'invention, est représenté en **Figure 8** dans laquelle la puce ne comprend que trois plots. Les premier et troisième plots sont reliés aux entrées/sorties du microprocesseur, la première capacité C1 est connectée entre les premier et deuxième plots P1 et P2, la deuxième capacité C2 est connectée entre les deuxième et troisième plots P2 et P3. Le module électronique comprend une antenne 3a connectée entre les premier et troisième plots P1 et P3 et une deuxième antenne 3b connectée entre les deuxième et troisième plots P2 et P3. Dans cet exemple la première capacité C1 réalise l'accord des antennes et la deuxième capacité C2 amplifie l'énergie captée par celles-ci et délivrée à la puce.

Une telle puce microélectronique permet ainsi de prévoir différents montages permettant d'assurer une alimentation électrique correcte de la puce, sans nécessiter la présence d'antenne dans un corps de carte, et tout en respectant les contraintes de faible surface disponible imposées par les petites dimensions du module électronique au sein de laquelle la puce est disposée.

## Revendications

1. Module électronique (2) pour carte à puce à fonctionnement sans contact ou à fonctionnement dual à contact et sans contact, comprenant au moins une première antenne (3a), une seconde antenne (3b), une troisième antenne (3c) et une puce microélectronique (1), **caractérisé en ce que** :
ladite puce microélectronique comprend un microprocesseur, au moins un premier plot (P1), un deuxième plot (P2), un troisième plot (P3), un quatrième plot (P4), une première capacité d'accord (C1) connectée entre le premier plot (P1) et le troisième plot (P3), une deuxième capacité (C2) connectée entre le deuxième plot (P2) et le quatrième plot (P4), lesdits premier et troisième plots (P1, P3) étant reliés aux entrées/sorties du microprocesseur et aptes à assurer la transmission à celui-ci d'un signal de communication radiofréquence échangé via les antennes,
ladite première antenne (3a) est connectée entre le premier plot (P1) et le troisième plot (P3) et configurée pour être mise en résonance par ladite première capacité (C1),
ladite seconde antenne (3b) est connectée entre le quatrième plot (P4) et ladite troisième antenne (3c) et configurée pour être mise en résonance grâce à la deuxième capacité (C2) pour capter de l'énergie transmise par induction par un lecteur distant,
ladite troisième antenne (3c) est branchée en série avec ladite seconde antenne (3b) entre le deuxième plot (P2) et ladite seconde antenne (3b) pour transmettre l'énergie captée à la puce microélectronique (1) et couplée avec la première antenne (3a) pour transférer l'énergie captée par la seconde antenne (3b) à la puce microélectronique (1) par l'intermédiaire de la première antenne (3a).

2. Module électronique (2) selon la revendication 1 dans lequel la deuxième capacité (C2) est une capacité variable.

3. Module électronique selon l'une des revendications précédentes dans lequel la puce microélectronique comprend une résistance variable (R) connectée en série avec la deuxième capacité (C2) entre le deuxième plot (P2) et le quatrième plot (P4).

## Patentansprüche

1. Elektronisches Modul (2) für Chipkarte mit kontaktloser Funktionsweise oder dualer Funktionsweise mit Kontakt und ohne Kontakt, aufweisend mindestens eine erste Antenne (3a), eine zweite Antenne (3b), eine dritte Antenne (3c) und einen mikroelektronischen Chip (1), **dadurch gekennzeichnet, dass**:
der mikroelektronische Chip einen Mikroprozessor, mindestens einen ersten Plot (P1), eine zweiten Plot (P2), einen dritten Plot (P3), einen vierten Plot (P4), eine erste Übereinstimmungskapazität (C1), geschaltet zwischen dem ersten Plot (P1) und dem dritten Plot (P3), eine zweite Kapazität (C2), geschaltet zwischen dem zweiten Plot (P2) und dem vierten Plot (P4), umfasst, wobei der erste und dritte Plot (P1, P3) mit den Eingängen/Ausgängen des Mikroprozessors verbunden sind und imstande, die Übertragung eines über die Antennen ausgetauschten Funkfrequenz-Kommunikationssignals an diesen zu sichern,
wobei die erste Antenne (3a) zwischen dem ersten Plot (P1) und dem dritten Plot (P3) geschaltet ist und konfiguriert, um von der ersten Kapazität (C1) in Resonanz gebracht zu werden,
wobei die zweite Antenne (3b) zwischen dem vierten Plot (P4) und der dritten Antenne (3c) geschaltet ist und konfiguriert, um dank der zweiten Kapazität (C2) in Resonanz gebracht zu werden, um die durch Induktion von einem entfernten Lesegerät übertragene Energie zu empfangen,
wobei die dritte Antenne (3c) mit der zweiten Antenne (3b) zwischen dem zweiten Plot (P2) und der zweiten Antenne (3b) in Reihe geschaltet ist, um die empfangene Energie an den mikroelektronischen Chip (1) zu übertragen, und mit der ersten Antenne (3a) gekoppelt ist, um die von der zweiten Antenne (3b) empfangene Energie an den mikroelektronischen Chip (1) über die erste Antenne (3a) zu übertragen.

2. Elektronisches Modul (2) nach Anspruch 1, wobei die zweite Kapazität (C2) eine variable Kapazität ist.

3. Elektronisches Modul nach einem der vorangehenden Ansprüche, wobei der mikroelektronische Chip einen variablen Widerstand (R) umfasst, der mit der zweiten Kapazität (C2) zwischen dem zweiten Plot (P2) und dem vierten Plot (P4) in Reihe geschaltet ist.

## Claims

1. An electronic module (2) for a contactless smart card or dual contact and contactless smart card comprising at least a first antenna (3a), a second antenna (3b), a third antenna (3c) and a microelectronic chip (1), **characterized in that**:
said microelectronic chip comprises a microprocessor, at least a first contact (P1), a second contact (P2), a third contact (P3), a fourth contact (P4), a first tuning capacitor (C1) connected between the first contact (P1) and the third contact (P3), a second capacitor (C2) connected between the second contact (P2) and the fourth contact (P4), said first and third contacts (P1, P3) being connected to the inputs/outputs of the microprocessor and capable of transmitting to the microprocessor a radio-frequency communication signal exchanged through the antennas,
said first antenna (3a) is connected between the first contact (P1) and the third contact (P3) and configured to be brought into resonance by said first capacitor (C1),
said second antenna (3b) is connected between the fourth contact (P4) and said third antenna (3c) and configured to be brought into resonance using the second capacitor (C2) to capture the energy transmitted by induction by a remote reader,
said third antenna (3c) is connected in series with said second antenna (3b) between the second contact (P2) and said second antenna (3b) for transmitting the captured energy to the microelectronic chip (1) and coupled with the first antenna (3a) for transferring the energy captured by the second antenna (3b) to the microelectronic chip (1) through the first antenna (3a).

2. The electronic module (2) according to claim 1, wherein the second capacitor (C2) is a variable capacitor.

3. The electronic module according to one of the preceding claims, wherein the microelectronic chip comprises a variable resistor (R) connected in series with the second capacitor (C2) between the second contact (P2) and the fourth contact (P4).
